Europäisches Patentamt

European Patent Office

Office européen des brevets

(11) Publication number: **0 010 907**
**B1**

(12) **EUROPEAN PATENT SPECIFICATION**

(45) Date of publication of patent specification: **17.08.83**

(21) Application number: **79302274.0**

(22) Date of filing: **19.10.79**

(51) Int. Cl.³: **G 11 C 7/00, G 11 C 11/24, G 11 C 7/02**

(54) Semiconductor memory device including a flip-flop circuit.

(30) Priority: **26.10.78 JP 132049/78**

(43) Date of publication of application:
**14.05.80 Bulletin 80/10**

(45) Publication of the grant of the patent:
**17.08.83 Bulletin 83/33**

(84) Designated Contracting States:
**DE FR GB NL**

(56) References cited:
**DE - A - 2 658 655**
**DE - A - 2 724 646**
**DE - A - 2 812 657**
**US - A - 3 678 473**
**US - A - 4 038 646**
**US - A - 4 050 061**
**US - A - 4 054 865**
**US - A - 4 085 457**
**US - A - 4 086 662**
**US - A - 4 087 704**
**US - A - 4 122 546**

(73) Proprietor: **FUJITSU LIMITED**
**1015, Kamikodanaka Nakahara-ku**
**Kawasaki-shi Kanagawa 211 (JP)**

(72) Inventor: **Nakano, Masao**
**473-4 Hisasue Takatsu-ku**
**Kawasaki-shi Kanagawa (JP)**
Inventor: **Nakano, Tomino**
**7-9 Miyazaki 2-chome Takatsu-ku**
**Kawasaki-shi Kanagawa (JP)**
Inventor: **Takemae, Yoshihiro**
**10-1 Miyazaki 1-chome Takatsu-ku**
**Kawasaki-shi Kanagawa (JP)**
Inventor: **Kabashima, Katsuhiko**
**407-1 Miyauchi Nakahara-ku**
**Kawasaki-shi Kanagawa (JP)**

(74) Representative: **Rackham, Stephen Neil et al,**
**GILL JENNINGS & EVERY 53-64 Chancery Lane**
**London WC2A 1HN (GB)**

(56) References cited:
**INTEL DATA SHEET, July 1971, Santa Clara, US**
**"Silicon gate MOS LSI RAM 1103, fully decoded random access 1024 bit dynamic memory", 16 pages**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

**0 010 907**

ELECTRONICS, vol. 49, no. 10, 13 May 1976,
New York US KUO et al. "16K RAM built with
proven process may offer high start-up
reliability", pages 81—85

**0 010 907**

Semiconductor memory device including a flip-flop circuit

This invention relates to a semiconductor memory device including a flip-flop circuit. Such semiconductor memory devices are subject to erroneous operation due to noise induced in conductors connected to input terminals of the flip-flop circuit.

Such prior art semiconductor memory devices including flip-flop circuits are disclosed in, for example, United States Patent Specification No. 3514765 and a thesis entitled "The Design of MOS Dynamic RAMs" by R. C. Foss, delivered to the 1979 IEEE International Solid-state Circuits Conference.

The problem with this type of semiconductor memory is that an unwanted noise signal is generated in data bus lines which cross bit lines leading to and from the flip-flop circuits. One example of attempts which have been made to reduce the effect of the induced noise is shown in Figure 4 of Intel Data Sheet July 1971 "Silicon gate MOS LSI RAM 1103, fully decoded random access 1024 bit dynamic memory". In this example, a second conductor is placed near to the data bus line so that the same noise signal will be generated in this additional conductor as is generated in the data bus line. The semiconductor device then includes a differential amplifier connected to both conductors and thus, the common signal induced in both of the conductors is cancelled out in the differential amplifier.

In accordance with an embodiment of this invention, a semiconductor memory device including flip-flop circuits comprises first bit lines on one side of the flip-flop circuits, second bit lines on the other side of the flip-flop circuits, each flip-flop circuit being connected to a respective one of the first bit lines and to a respective one of the second bit lines so as to amplify a potential difference arising between said lines during reading, a first data bus line operatively connected to and crossing the first bit lines, a second data bus line operatively connected to and crossing the second bit lines, said data bus lines being connected to an input/output amplifier, and further comprises a first dummy line arranged adjacent and parallel with the first data bus line and connected to the second data bus line, and a second dummy line arranged adjacent and parallel to the second data bus line and connected to the first data bus line so that the noise generated by the coupling between the first bit lines and the first data bus line and between the second bit lines and the second data bus line is cancelled.

A device in accordance with the present invention has the advantage that erroneous operations of the semiconductor memory device are prevented from occurring by cancelling out noise induced in the data bus. A particular example of the device in accordance with this invention will now be described and contrasted with the prior art with reference to the accompanying drawings; in which:—

Figure 1 is a circuit diagram of a prior art semiconductor memory device including flip-flop circuits;

Figure 2 is a circuit diagram of a semiconductor memory device including flip-flop circuits in accordance with the present invention; and,

Figure 3 illustrates a series of wave forms showing the operation of the devices shown in Figure 1 and Figure 2.

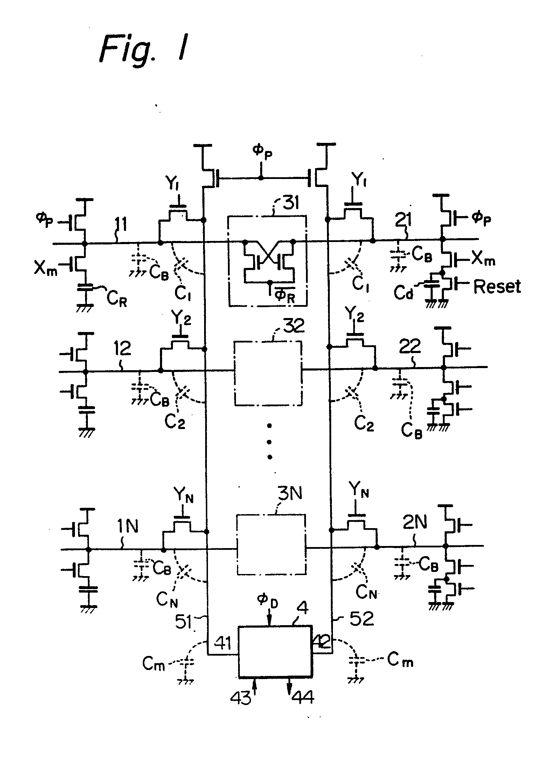

An example of a prior art semiconductor memory device using MOS FETs is illustrated in Figure 1. In Figure 1, the semiconductor memory device comprises sense amplifiers 31, 32,....,3N which read-out the information stored in memory elements and an input/output (I/O) amplifier 4. Each of the sense amplifiers 31, 32,....,3N and the I/O amplifier 4 consists of a flip-flop circuit. Each of the sense amplifiers 31, 32,....,3N is connected to a pair of bit lines 11, 21; 12, 22;...; 1N, 2N; respectively. The I/O amplifier 4 is connected to a pair of data bus lines 51, 52.

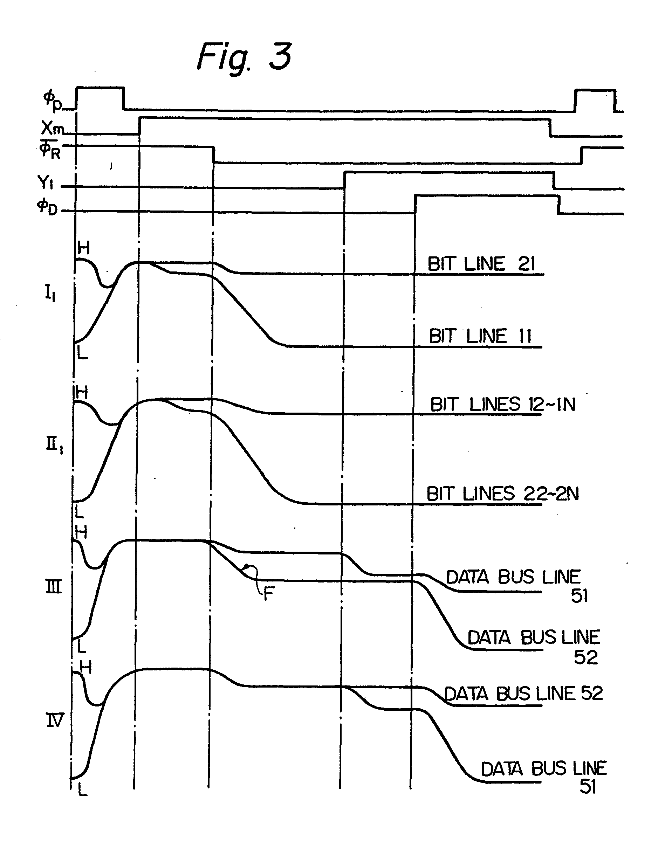

When the sense amplifiers 31, 32,....,3N amplify the signals on the bit lines 11, 21; 12, 22;...; 1N, 2N in accordance with the read clock signal $\overline{\phi R}$, noise is induced in the data bus lines 51, 52 from the bit lines 11, 21; 12, 22;...; 1N, 2N due to the existence of the coupling capacitances $C_1$, $C_2$,...$C_N$. To explain the possible effects of this noise it is assumed that the information to be read out of the pair of bit lines 11, 21 is the opposite of that existing in the pairs of bit lines 12, 22, through 1N, 2N so that of the bit lines 11, 12,....,1N only the line 11 changes potential significantly during reading, whereas of the bit lines 21, 22,....,2N, line 21 is the only one which does not change potential significantly (as is explained further below, with respect to Figure 3); this represents a worst case. The value of the noise $\Delta VN_2$ induced in the data bus line 52 by the potential changes on lines 22, 23...,2N is represented by the equation (1) below.

$$\Delta VN_2 = -\frac{\sum\limits_{k=1}^{N} C_k}{C_m + \sum\limits_{k=1}^{N} C_k} \cdot \Delta V_{B2} \qquad (1)$$

Here, $C_m$ is the capacitance between the data bus line 52 and the ground and $\Delta V_{B2}$ is the variation of the voltage in each of the bit lines 22, 23...2N. The value of the noise $\Delta VN_1$ induced in the data bus line

3

51 by the variation of the voltage on lines 11, 12,...1N is equal to approximately zero, since only line 11 varies significantly, i.e.

$$\Delta VN_1 \doteqdot 0 \qquad (2)$$

The input voltage $V_s$ applied to the I/O amplifier 4 is represented by the equation (3) below.

$$V_s = -\frac{C_B}{C_m + \sum\limits_{k=1}^{N} C_k} \cdot \Delta V_{B1} \qquad (3)$$

Here, $C_B$ is the capacitance between the bit line and the ground and $\Delta V_{B1}$ is the variation of the bit line 11 voltage.

In the case where the data of the cell to be read-out is the same as the data of the cells not to be read-out, the phase of the noise $\Delta VN_2$ of the equation (1) is the same as the phase of the voltage $V_s$ of the equation (3), and, accordingly, no erroneous operation of the I/O amplifier 4 is caused. On the contrary, in the above worst case where the data of the cell to be read-out is opposite to the data of the cells not to be read-out, the phase of the noise $\Delta VN_2$ of the equation (1) is the reverse of the phase of the voltage $V_s$ of the equation (3), and, accordingly an erroneous operation of the I/O amplifier 4 is caused if the absolute value of the noise $\Delta VN_2$ is greater than the absolute value of the voltage $V_s$.

The operation of the circiuit is illustrated by the wave forms I, II and III of Figure 3.

At first, when the precharge clock signal $\phi p$ is applied to the gates of the FETs connected to the bit lines 11 and 21, the potentials (H, L) of the bit lines 11 and 21 start to change so as to be equalised and caused to attain high level as shown in the waveform I. Then, when the signal Xm is applied to the gate of the FET connected to the real cell $C_R$, the equalised potentials of the bit lines 11 and 21 are caused to become different. Then, when the read clock signal $\phi R$ is applied to the sense amplifier 31, the sense amplifier 31 starts to operate so that the potential difference between the bit lines 11 and 21 is caused to be enlarged. Thus, the potentials of the bit lines 11 and 21 are brought to the low level (L) and the high level (H), respectively, as shown in the form I.

It is again assumed that the changes of the potentials of the bit lines 12, 22 through 1N, 2N from which no stored information is to be read-out are reverse to those of the bit lines 11, 21 as shown in the wave form II.

The process of the change of the potentials of the data bus lines 51 and 52 under the effect of the noise induced from the bit lines is illustrated in the wave form III. Due to the existance of the noise $\Delta VN_2$ of the equation (1), the potential of the data bus line 52 falls (F) as shown in the wave form III. Under these conditions, when the decoder signal $Y_1$ is applied to the FETs connected between the bit lines 11, 21 and the data bus lines 51, 52 and the data clock signal $\phi_D$ is applied to the I/O amplifier 4, the potential of the data bus line 51 remains high level and the potential of the data bus line 52 is caused to become a low level. The potential distribution between the data bus lines 51 and 52 reversely corresponds to the potential distribution between the bit lines 11 and 21 in the wave form I. Accordingly, the potential distribution between the data bus lines 51 and 52 shows an erroneous operation due to the induced noise.

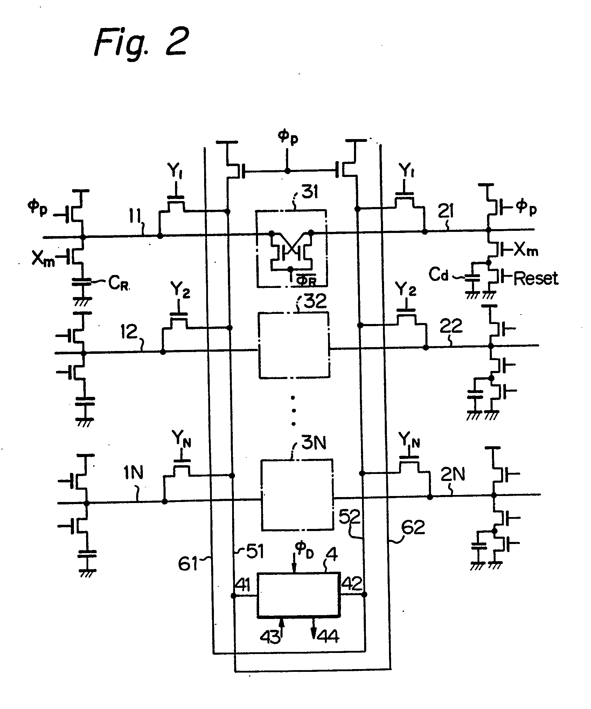

In Figure 2, the circuit of the semiconductor memory device including flip-flop circuits in accordance with the present invention is illustrated. The sense amplifiers 31, 32,..., 3N are provided corresponding to the pairs of bit lines 11, 21; 12, 22;...1N, 2N. The terminals of the I/O amplifier 4 are connected to the data bus lines 51 and 52. A dummy line 61 is arranged adjacent to and parallel with the data bus 51 crossing the bit lines 11, 12,...,1N. An end of the dummy line 61 is connected to a terminal 42 of the I/O amplifier 4 to which the data bus line 52 is connected. Another dummy line 62 is arranged adjacent to and parallel with the data bus line 52 crossing the bit lines 21, 22,...,2N. An end of the dummy line 62 is connected to the other terminal 41 of the I/O amplifier 4 to which the data bus line 51 is connected. Except for the addition of the dummy lines 61 and 62, the structure of the circuit of Figure 2 is the same as that of Figure 1.

As a modification of the arrangements of the dummy lines, it is possible to arrange the dummy lines 61 and 62 parallel with the data bus lines 51 and 52 but not adjacent the data bus lines 51 and 52, respectively. Also, it is possible to connect the dummy lines 61 and 62 to the data bus lines 52 and 51 at the points other than the connecting points between the data bus lines 52 and 51 and the I/O amplifier 4.

The operation of the circuit shown in Figure 2 will now be explained. When the signal Xm is applied to the gate of the FET connected to the real cells $C_R$, the information stored in the real cells $C_R$ is transmitted to the bit line 11. This transmitted information is represented by the signal of small voltage such as 100 milli volts to 200 milli volts. Then, when the read clock signal $\phi R$ is applied to the sense amplifier 31, said signal of small voltage is caused to be amplified by the sense amplifier 31 so that the potentials of the bit lines 11 and 21 are caused to attain the level of 5 volts (power source voltage) and zero volt, respectively. For the same time, the noise $\Delta VN_2$, represented by the equation (1) is induced in the data bus line 52 from the bit line through the coupling capacitance between the data bus line 52 and the bit lines 21, 22,...,2N.

When the column decoder signal $Y_1$ is applied to the FETs connected between the bit lines 11, 21 and the data bus lines 51, 52, the signals on the bit line 11, 21 are transmitted to the data bus lines 51, 52, so that the signal $V_s$ represented by the equation (3) is established between the data buses 51 and 52.

If no dummy lines 61, 62 were provided, the total input voltage $V'_t$ to the I/O amplifier would be as follows.

$$V'_t = V_s + (\Delta VN_1 - \Delta VN_2) \qquad (4)$$

Accordingly, if the absolute value of $\Delta VN_2$ is greater than the absolute value of $V_s$, the signal $V_s$ will be cancelled by the noise $\Delta VN_2$ and the signal representing the noise $\Delta VN_2$ will be applied to the input of the I/O amplifier 4. This will cause an erroneous operation of the I/O amplifier 4.

However, the dummy lines 61 and 62 are provided in the circuit of Figure 2. Because of the presence of the dummy lines 61 and 62, the total input voltage $V_t$ to the I/O amplifier 4 is as follows.

$$V_t = V_s + (\Delta VN_1 - \Delta VN_2) + (\Delta VN_{2d} - \Delta VN_{1d}) \qquad (5)$$

Here, $\Delta VN_{1d}$ and $\Delta VN_{2d}$ are the noises induced in the dummy lines 61 and 62, respectively. Since the noise $\Delta VN_1$ induced in the data bus 51 is equal to the noise $\Delta VN_{1d}$ induced in the dummy line 61 and the noise $\Delta VN_2$ induced in the data bus 52 is equal to the noise $\Delta VN_{2d}$ induced in the dummy line 62, the total input voltage $V_t$ to the I/O amplifier 4 becomes equal to $V_s$. That is,

$$V_t = V_s \qquad (6)$$

Accordingly, the I/O amplifier 4 receives the correct input signal so that no erroneous operation of the I/O amplifier occurs.

When the data clock signal $\phi_D$ is applied to the I/O amplifier 4, the potential difference between the terminals 41 and 42 is amplified in the I/O amplifier 4, and an output signal is obtained at the output 44 of the I/O amplifier 4.

The change of the potentials of the data bus lines 51 and 52 is illustrated in the wave form IV in Figure 3. No fall of the potentials of the data bus lines 52 due to the noise $VN_2$, such as "F" in the wave form IIII, occurs in the wave form IV. Accordingly, the potential distribution between the data bus lines 51 and 52 correctly corresponds to the potential distribution between the bit lines 11 and 21 in the wave form I. This shows the correct operation of the circuit of Figure 2.

**Claims**

1. A semiconductor memory device (Figure 2) including flip-flop circuits (31, 32,...3N), comprising first bit lines (11, 12,...1N) on one side of the flip-flop circuits second bit lines (21, 22,...2N) on the other side of the flip-flop circuits, each flip-flop circuit (e.g. 31) being connected to a respective one of the first bit lines (e.g. 11) and a respective one of the second bit lines (e.g. 21) so as to amplify a potential difference arising between said lines during reading, a first data bus line (51) operatively connected to and crossing the first bit lines (11, 12,...1N), a second data bus line (52) operatively connected to and crossing the second bit lines (21, 22,...2N), said data bus lines (51, 52) being connected to an input/output amplifier (4), further comprising a first dummy line (61) arranged adjacent and parallel with the first data bus line (51) and connected to the second data bus line (52), and a second dummy line (62) arranged adjacent and parallel to the second data bus line (52) and connected to the first data bus line (51) so that noise generated by the coupling between the first bit lines and the first data bus lines and between the second bit lines and the second data bus line is cancelled.

2. A semiconductor memory device (Fig. 2) comprising a plurality of flip-flop circuits (31, 32,...,3N), first bit lines (11, 12,...1N) on one side of the flip-flop circuits, second bit lines (21, 22,...2N) on the other side of the flip-flop circuits each flip-flop circuit (e.g. 31) being connected to a respective one of the first bit lines (e.g. 11) and a respective one of the second bit lines (e.g. 21) so as to amplify a potential difference arising between said lines during reading, a first data bus line (51) operatively connected to each of the first bit lines (11, 12,...,1N), a second data bus line (52), operatively connected to each of the second bit lines (21, 22,...2N), a first dummy line (61) parallel to the first data bus line (51) and connected to the second data bus line (52) at a first node (42), a second dummy line (62) parallel to the second data bus line (52) and connected to the first data bus line (51) at a second node (41), and an input/output amplifier circuit (4) operatively connected between the first (42) and second (41) nodes, so that the first and second dummy lines (61, 62) substantially reduce the erroneous operation of the input/output amplifier circuit due to noise.

3. A semiconductor memory device according to claim 2, further comprising a first plurality of FETs which are operatively connected to the bit lines, and which transmit the information from selected storage cells ($C_R$) to the bit lines in response to a control signal ($X_m$) and a second plurality of FETs operatively connected to a column decoder and operatively connecting a selected first bit line (11, 12,...1N) to the first data bus line (51), and the corresponding second bit line (21, 22,...2N) to the second data bus line (52) in response to signals ($Y_1$, $Y_2$, $Y_N$) from the column decoder.

**Patentansprüche**

1. Halbleiterspeicheranordnung (Fig. 2) mit Flip-Flop-Schaltungen (31, 32,...3N), mit ersten Bitleitungen (11, 12,...1N) auf einer Seite der Flip-Flop-Schaltungen und zweiten Bitleitungen (21, 22,...2N) auf der anderen Seite der Flip-Flop-Schaltungen, in welcher jede Flip-Flop-Schaltung (z. B. 31) mit einer entsprechenden ersten Bitleitung (z. B. 11) und einer entsprechenden zweiten Bitleitung (z. B. 21) so verbunden ist, daß sieeine Potentialdifferenz verstärkt, welche beim Lesen zwischen den Leitungen entsteht, mit einer ersten Datensammelleitung (51), welche wirkungsmäßig mit den ersten Bitleitungen (11, 12,...1N) verbunden ist und diese kreuzt, einer zweiten Datensammelleitung (52), welche wirkungsmäßig mit den zweiten Bitleitungen (21, 22,...2N) verbunden ist und diese kreuzt, wobei die genannten Datensammelleitungen (51, 52) mit einem Eingabe/Ausgabe-Verstärker (4) verbunden sind, mit einer ersten Hilfsleitung (61), welche parallel und neben der ersten Datensammelleitung (51) angeordnet und mit der zweiten Datensammelleitung (52) verbunden ist, und mit einer zweiten Hilfsleitung (62), welche parallel zu der zweiten Datensammelleitung (52) neben dieser angeordnet und mit der ersten Datensammelleitung (51) verbunden ist, so daß Rauschen, welches durch die Kopplung zwischen den ersten Bitleitungen und der ersten Datensammelleitung und zwischen den zweiten Bitleitungen und der zweiten Datensammelleitung bei der Kopplung erzeugt wird, gelöscht wird.

2. Halbleiterspeicheranordnung (Fig. 2) mit Flip-Flop-Schaltungen (31, 32,...3N), mit ersten Bitleitungen (11, 12,...1N) auf einer Seite der Flip-Flop-Schaltungen und zweiten Bitleitungen (21, 22,...2N) auf der anderen Seite der Flip-Flop-Schaltungen in welcher jede Flip-Flop-Schaltung (z. B. 31) mit einer entsprechenden ersten Bitleitung (z. B. 11) und einer entsprechenden zweiten Bitleitung (z. B. 21) so verbunden ist, daß sie eine Potentialdifferenz verstärkt, welche beim Lesen zwischen den Leitungen entsteht, mit einer ersten Datensammelleitung (51), welche wirkungsmäßig mit den ersten Bitleitungen (11, 12,...1N) verbunden ist, einer zweiten Datensammelleitung (52), welche wirkungsmäßig mit den zweiten Bitleitungen (21, 22,...2N) verbunden ist, mit einer ersten Hilfsleitung (61), welche parallel zu der ersten Datensammelleitung (51) angeordnet und mit der zweiten Datensammelleitung (52) bei einem ersten Knotenpunkt (42) verbunden ist, mit einer zweiten Hilfsleitung (62), welche parallel zu der zweiten Datensammelleitung (52) angeordnet ist und mit der ersten Datensammelleitung (51) bei einem zweiten Knotenpunkt (41) verbunden ist, und mit einer Eingabe/Ausgabe-Verstärkerschaltung (4), welche zwischen dem ersten Knotenpunkt (42) und dem zweiten Knotenpunkt (41) geschaltet ist, so daß die erste und die zweite Hilfsleitung (61, 62) den durch Rauschen verursachten fehlerhaften Betrieb der Eingabe/Ausgabe-Verstärkerschaltung im wesentlichen reduzieren.

3. Vorrichtung nach Anspruch 2, dadurch gekennzeichnet, daß eine erste Anzahl von Feldeffekttransistoren (FETs) wirkungsmäßig mit den zweiten Bitleitungen verbunden sind und die Information von ausgewählten Speicherzellen ($C_R$) zu den Bitleitungen in Abhängigkeit von einem Steuersignal ($X_m$) übertragen, und daß eine zweite Anzahl von Feldeffekttransistoren (FETs) wirkungsmäßig mit einem Spaltendecoder verbunden sind und, in Abhängigkeit von Signalen ($Y_1$, $Y_2$,...$Y_N$) von dem Spaltendecoder, eine ausgewählte erste Bitleitung (11, 12,...1N) mit der ersten Datensammelleitung (51) und die entsprechende zweite Bitleitung (21, 22,...2N) mit der zweiten Datensammelleitung (52) verbinden.

**Revendications**

1. Dispositif de mémoire à semi-conducteurs (Fig. 2) comprenant des circuits bistables (31, 32,...3N) comportant des premières lignes de bits (11, 12,...1N) sur un côté des circuits bistables, des secondes lignes de bits (21, 22,...2N) sur l'autre côté des circuits bistables, chaque circuit bistable (p.e. 31) étant connecté à l'une respective des premières lignes de bits (p.e. 11) et à l'une respective des secondes lignes de bits (p.e. 21) de manière à amplifier une différence de potentiel apparaissant entre lesdites lignes pendant la lecture, une première ligne omnibus de données (51) connectée en fonctionnement et croisant les premières lignes de bits (11, 12,...1N), une seconde ligne omnibus de données (52) connectée en fonctionnement et croisant les secondes lignes de bits (21, 22,...2N) lesdites lignes omnibus de données (51, 52) étant connectées à un amplificateur d'entrée/sortie (4), et comportant en outre une première ligne fictive (61) disposée adjacente et parallèle à la première ligne omnibus de données (51) et connectée à la seconde ligne omnibus de données (52) et une seconde ligne fictive (62) disposée adjacente et parallèle à la seconde ligne omnibus de données (52) et connectée à la première ligne omnibus de données (51) de manière que les parasites produits par le couplage entre les premières lignes de bits et les premières lignes omnibus de données et entre les secondes lignes de bits et les secondes lignes omnibus de données soient annulés.

2. Dispositif de mémoire à semi-conducteurs (Fig. 2) comprenant plusieurs circuits bistables (31, 32,...3N), des premières lignes de bits (11, 12,...1N) sur un côté des circuits bistables, des secondes lignes de bits (21, 22,...2N) sur l'autre côté des circuits bistables, chaque circuit bistable (p.e. 31) étant connecté à l'une respective des premières lignes de bits (p.e. 11) et à l'une respective des secondes lignes de bits (p.e. 21) de manière à amplifier une différence de potentiel apparaissant entre lesdites lignes pendant la lecture, une première ligne omnibus de données (51) connectée en fonctionnement à chacune des premières lignes de bits (11, 12,...1N), une seconde ligne omnibus de données (52) connectée en fonctionnement à chacune des secondes lignes de bits (21, 22,...2N), une première ligne fictive (61) parallèle à la première ligne omnibus de données (51) et connectée à la seconde ligne omnibus de données (52) à un premier point (42), une seconde ligne fictive (62) parallèle à la seconde ligne omnibus de données (52) et connectée à la première ligne omnibus de données (51) à un second point (41), et un circuit amplificateur d'entrée/sortie (4) connecté en fonctionnement entre les premier (42) et second (41) points, de manière que les première et seconde lignes fictives (61, 62) réduisent substantiellement le fonctionnement erronné du circuit amplificateur d'entrée/sortie dû aux parasites.

3. Dispositif de mémoire à semi-conducteurs selon la revendication 2, comprenant en outre un premier nombre de transistors à effet de champ qui sont connectés en fonctionnement aux lignes de bits, et qui transmettent les informations provenant de cellules de mémorisation sélectionnées ($C_R$) aux lignes de bits en réponse à un signal de commande ($X_m$) et un second nombre de transistors à effet de champ connectés en fonctionnement à un décodeur de colonne, et connectant une première ligne de bits sélectionnée (11, 12,...1N) à la première ligne omnibus de données (51), et la seconde ligne de bits correspondante (21, 22,...2N) à la seconde ligne omnibus de données (52) en réponse aux signaux ($Y_1, Y_2,...Y_N$) provenant du décodeur de colonne.

# Fig. 1

*Fig. 2*

# *Fig. 3*